(19) Europäisches Patentamt

European Patent Office

Office européen des brevets

(11) Publication number: **0 393 947 A2**

## EUROPEAN PATENT APPLICATION

(21) Application number: 90304012.9

(22) Date of filing: 12.04.90

(51) Int. Cl.⁵: **H04N 5/262, H04N 9/76**

(30) Priority: **17.04.89 US 338687**

(43) Date of publication of application:
**24.10.90 Bulletin 90/43**

(84) Designated Contracting States:
**AT DE DK ES FR GB IT SE**

(71) Applicant: **THOMSON CONSUMER ELECTRONICS, INC.**
**600 North Sherman Drive**
**Indianapolis Indiana 46206(US)**

(72) Inventor: **Bell, Isaac Michael**
**8121 Taunton Road**
**Indianapolis, Indiana(US)**

(74) Representative: **Smith, Thomas Ian Macdonald et al**
**London Patent Operation G.E. Technical Services Co. Inc. Burdett House 15-16 Buckingham Street**
**London WC2N 6DU(GB)**

(54) **Switch arrangement.**

(57) First and second signals, with given bias levels are applied to respective inputs (out 1, out 2) of a non-additive mixer (NAM) circuit (100) through respective switches (SW1,SW2) which can be in a low-cost CMOS switch (30) to provide a cost effective switch for television signals. Each input of the NAM circuit is biased at a reference level (through R1,R3) in the absence of applied signal to it. The input receiving signal plus bias is enabled thereby to convey its respective signal to the output (40) of the NAM circuit (100), and the input receiving the reference bias level is prevented from conveying its respective signal to the output (40) of the NAM circuit (100).

FIG.1

## SWITCH ARRANGEMENT

This invention relates to the switching of analog signals, such as video signals in television receivers.

The term television receiver as used herein includes television receivers with a display device (commonly referred to as television sets), and television receivers without a display device, such as videocassette recorders (VCR's) and videodisc players.

Many modern television receivers include signal switching circuitry for selecting a video signal and an audio signal from a number of signal sources which may be connected to the receiver. The selected signals are processed and ultimately reproduced on a display screen, and at a speaker, respectively. Signal switches in television receivers need to be of high quality so as to not introduce distortion into the signals being passed through them. More importantly, these switches should present a high impedance to signals at their inputs when the switches are in the "off" (non-conducting) state. Due to the highly competitive nature of the consumer electronics business, these switches also must be inexpensive, especially for use in the "low end" (less expensive) television receivers. The characteristics of high quality and high "off state" impedance usually cause television signal switches to be fairly high cost items. For example, the TOSHIBA TA738P, a high quality switch often used in top-of-the-line television receivers, is approximately 5 times the price of the switch circuitry of the subject invention to be described below.

In contrast to the process of selecting a particular signal by means of a switch, it is well known to combine analog signals by means of an analog inclusive-OR circuit, commonly known as a non-additive mixer (NAM) circuit. A representative patent disclosing a NAM circuit is U.S. patent 4,583,121 (Yost), issued 15 April 1986. Conventional NAM circuits are not particularly well suited for use as switching circuits, because NAM circuits do not provide a selected signal, but rather they provide a combined analog output signal which is equal in amplitude to the amplitude of the greater of the signals at the NAM circuit inputs.

It is herein recognized that a non-additive mixer (NAM) circuit may be used as a switch by forward biasing one input of the NAM circuit and reverse-biasing the other input or inputs. This is accomplished by applying first and second signals, and first and second bias levels of different magnitudes to respective inputs of a level-gated-analog-OR circuit comprising a non-additive mixer (NAM) circuit. The input receiving the greater bias level is enabled thereby to convey its respective signal to the output of the NAM circuit, and the input receiving the lesser bias level is prevented from conveying signal to the output of the NAM circuit.

In an embodiment of the invention, a much simpler (and therefore much less expensive) CMOS switching integrated circuit (i.e., simpler than the TOSHIBA television signal switch described above) is utilized to provide a selected signal and bias voltage to one input of a level-gated-analog-OR circuit comprising a NAM arrangement, while the other input is substantially maintained at a low level.

The term "level-gated-analog-OR circuit", as used herein, refers to a circuit having multiple inputs for receiving respective signals, one signal of which occupies a higher bias level than the others. An output signal is developed in response to the input signal having the higher bias level, and not in response to the other input signals at the lower bias level.

In the accompanying drawings:

FIGURE 1 illustrates, partly in block diagram form and partly in schematic form, an embodiment of the invention comprising a switch arrangement disposed in series with NAM circuitry.

FIGURE 1a illustrates a waveform suitable as an input signal for the arrangement of FIGURE 1.

FIGURE 2 illustrates, in schematic form, an analog signal and bias source suitable for use in the arrangement of FIGURE 1.

FIGURE 3 illustrates, partly in block diagram form and partly in schematic diagram form, another embodiment.

FIGURES 3a and 3b illustrate waveforms useful in understanding the embodiment of FIGURE 3.

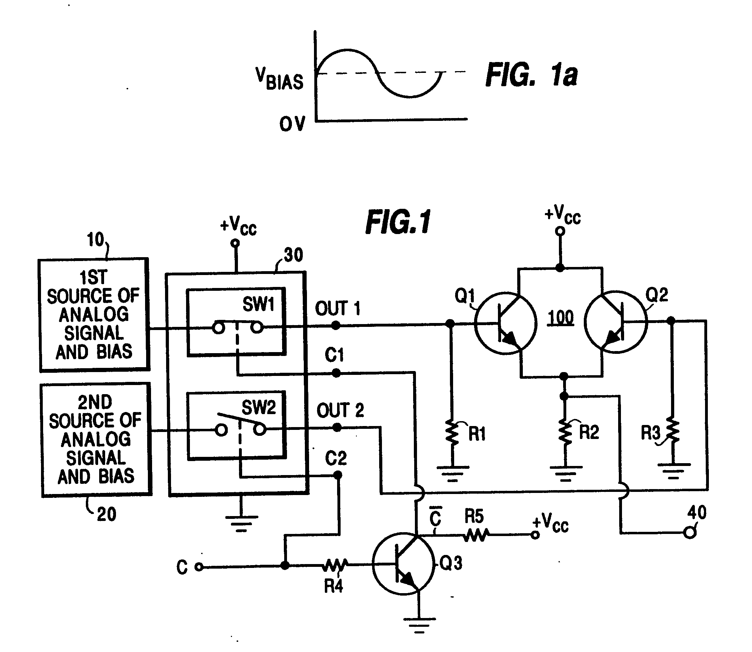

Referring to FIGURE 1, a non-additive mixer (NAM) circuit 100 comprises two transistors Q1 and Q2 having their respective collector electrodes coupled together and to a source of supply voltage VCC, and having respective emitter electrodes connected together and to one end of a single emitter resistor R2, the other end of which is returned to ground. A multiple switch unit 30 is disposed between signal and bias sources 10 and 20, and respective base electrodes of transistors Q1 and Q2. Switch unit 30 may be a CD 4016B CMOS quad-switch device manufactured by Harris Semiconductor Corporation, Somerville, New Jersey. A CD 4016B includes, in a single integrated circuit, the electronic equivalent of four single-pole single-throw switches, only two (i.e., SW1 and SW2) of which are shown for clarity. Each of these switches has an individual respective control terminal C1 and C2 associated with it. Complementary control signals C and $\overline{C}$ for controlling switches SW1 and SW2 of switch unit 30 are produced by an inverter circuit comprising a transistor Q3 and resistors R4 and R5. Binary control signal·C is applied to control input C2 for controlling switch SW2, and complementary control signal $\overline{C}$ is applied to control input C1 of switch SW1, so that when switch SW1 is closed, switch SW2 is open.

In operation, signal and bias sources 10 and 20 produce signals biased as shown in FIGURE 1a, and apply them to respective inputs of switch unit 30. FIGURE 1a illustrates an analog signal impressed upon a DC level (V BIAS) such that the lowest negative excursion of the analog signal is at a positive potential of at least 1VBE with respect to a zero volt reference point. The analog waveform is illustrated as a sine wave for simplicity, but may be, for example, an audio or video signal. If binary control signal C is at low level, then complementary control signal $\overline{C}$ is at a high level, causing SW1 to be closed and SW2 to be open, as shown in FIGURE 1. Accordingly, signals from signal and bias source 10 are coupled to the base of transistor Q1, causing Q1 to function as an emitter follower and to reproduce this signal at output 40. Transistor Q2 has no signal driving its base because switch SW2 is open, causing the base of transistor Q2 to be held at a ground potential by resistor R3. Therefore, transistor Q2 is reverse biased by the signal and bias present on its emitter electrode and presents a high impedance to signals which may be present on its base electrode. Specifically, Q1 produces an analog signal across emitter resistor R2 which is a reproduction of the signal at the base of Q1 but impressed upon a DC level which is 1VBE (approximately 0.7V) lower than the DC level produced by signal and bias source 10. Transistor Q2 is cut off from conduction due to a reverse bias condition resulting from a zero volt level at its base electrode and a DC level of $V_{BIAS} - 1V_{BE}$ at its emitter. That is, the bias level of the active signal further cuts off conduction in the non-active transistor associated with the non-selected signal. By use of the arrangement of FIGURE 1, one of two signals is provided at a single low impedance point 40 (i.e., the emitter of emitter follower transistor Q1 or Q2).

Under the conditions described above, transistor Q2 is not conducting, and its high impedance state is in cascade (in series) with the high impedance of open switch SW2, thus further reducing any signal which may have leaked through open switch SW2. Leakage of signal across the open switch contacts (sometimes called crosstalk) of the individual switches of a CD4016B is typically approximately -46 db. By adding transistor array 100 (i.e., the NAM circuit) as shown in FIGURE 1, the crosstalk is further reduced by approximately an additional 20db, which is of high enough quality to permit the use of this switching arrangement in a top-of-the-line television receiver.

In FIGURE 1, transistor switch arrangement 100 serves at least three purposes. First, it directs the output signals of signal and bias units 10 and 20 into a single output line at point 40. Second, it provides impedance transformation from the relatively high switch impedance of switch unit 30 to a low impedance at point 40. This reduces tendency to "pick-up" stray interfering signals from other circuitry (e.g., horizontal rate pulses from the horizontal deflection circuitry). Third, it provides additional isolation to further reduce any leakage of signal which may occur through open contacts of switch unit 30.

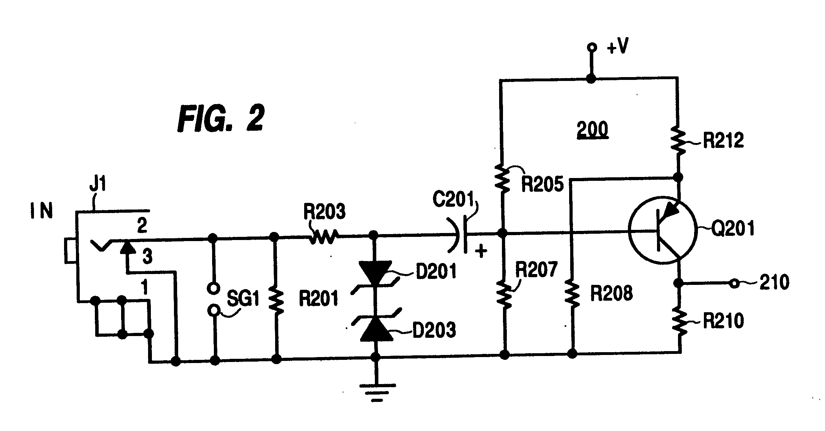

Referring to FIGURE 2, a circuit is shown which is suitable for use as signal bias sources 10 and 20. An external source of signal (not shown) is coupled to input terminal (or jack) J1, which is of the type which "shorts" the input line to ground (via terminals 2 and 3) when a connector is not plugged in. Resistor 201 is a terminating resistor and, as such, typically has a value of, for example, 75 ohms. Resistor 203 and diodes D201 and D203 form an input protection network for limiting electrostatic discharge (ESD) or high amplitude signals which may be applied. Likewise, a spark gap SG1 is provided for protection against electrostatic discharge. The input analog signal is coupled via coupling capacitor C201 to an amplifier stage 200 which inverts the signal, amplifies it and clamps it to a predetermined level. Amplifier 200 comprises a transistor Q201 base bias resistors R205 and R207, an emitter resistor R212 coupled to +V, a resistor R208 coupled to ground, and a collector resistor R210. Resistor R208 shunts current around Q201 and R210 and thereby affects the DC signal level at the output terminal 210 without affecting the gain of amplifier 200. In operation, amplifier 200 inverts the signal applied to its base, and clamps negative excursions of the input signal to the positive supply potential. Thus, the input signal is amplified and is impressed upon a bias value, as required by the switch circuitry of FIGURE 1.

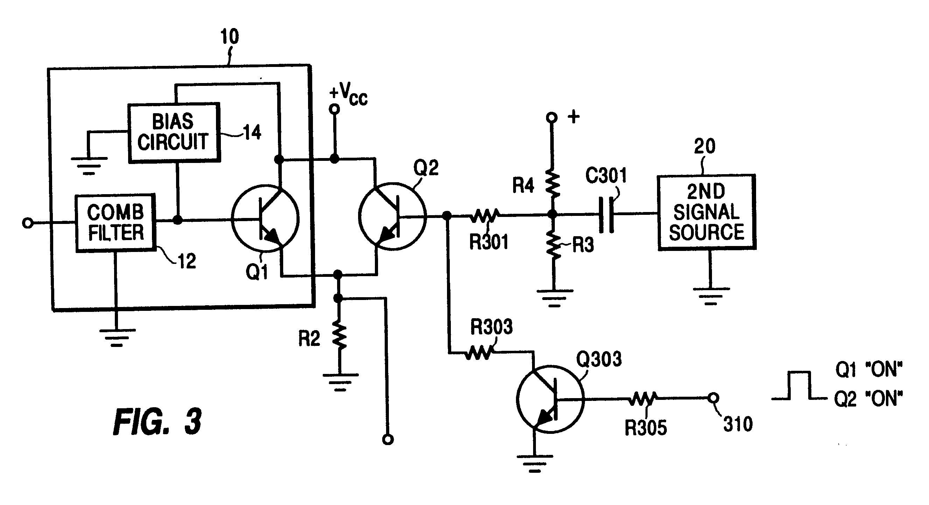

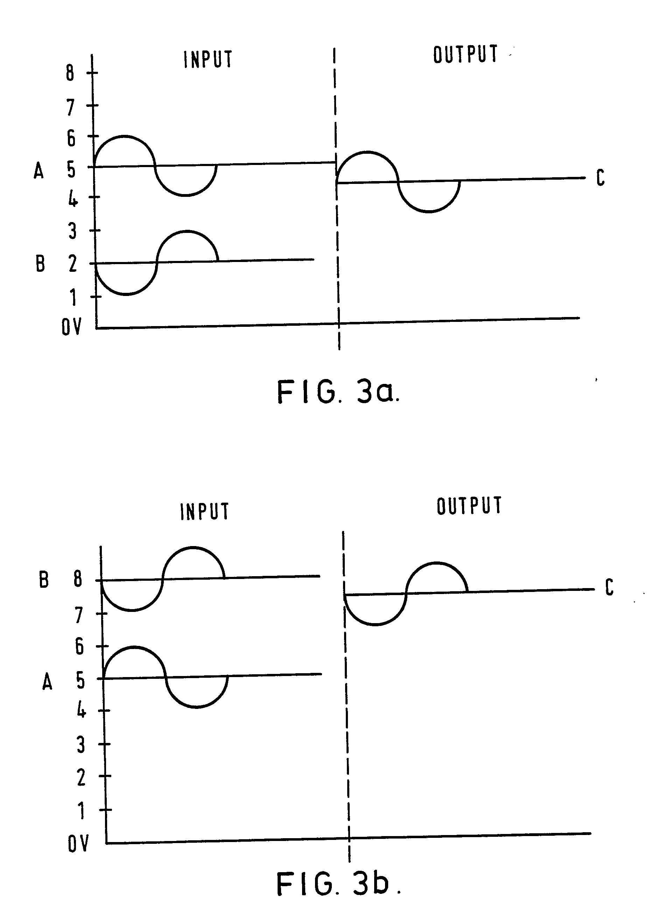

In FIGURE 3, elements bearing the same reference numbers as those in FIGURE 1 serve the same function, and therefore need not be described again.

Referring to FIGURE 3, the base electrode of transistor Q1 is coupled to receive an analog signal produced by a first analog signal and bias unit 10, which may include, for example, a comb filter 12, and a bias circuit 14. Transistor Q1 may be included within analog signal and bias unit 10 which may be, for example, a comb filter unit such as the CF2601K comb filter manufactured by TDK Corporation. The base electrode of transistor Q2 is coupled to a bias network comprising resistor R3 and resistor R4, and is AC coupled via capacitor C301 to receive an analog signal produced by a second analog signal and bias unit 20 which may be, for example, a source of video or chrominance signal, such as, an SVIDEO video or chroma signal input terminal.

Operation of the circuitry of FIGURE 3 will be explained with reference to the waveforms of FIGURE 3a and 3b. FIGURE 3a shows two input waveforms, A and B, which for purposes of explanation only, are shown as sine waves of opposite phase. In actual practice, these signals may be television audio or video signals having little or no phase relationship to one another. The signal of waveform A is biased at a DC level of approximately 5 volts and is applied to the base electrode of transistor Q1 of FIGURE 3.

The signal of waveform B is biased at approximately 2 volts DC and is applied to the base of transistor Q2. Transistor Q1 is forward-biased and reproduces its signal -1 VBE drop across emitter resistor R2, as shown in FIGURE 3a as output wavveform C. Transistor Q2 is reversed-biased because waveform C is, at all points, more positive than is waveform B, which is applied to the base of Q2.

Referring to FIGURE 3b, the signal of waveform A, applied to the base of transistor Q1, remains biased at a fixed level of approximately 5 volts DC. The signal of waveform B, however, is biased at approximately 8 volts DC, and is applied to the base of transistor Q2. This causes transistor Q2 to conduct and develop a signal of the type shown in waveform C of FIGURE 3b, across emitter resistor R2. The output signal of waveform C is biased at approximately 7.3 volts DC, and is thus at a significantly greater level than the signal applied to the base of transistor Q1, causing transistor Q1 to be reverse-biased.

Note that in the examples of FIGURE 3a and 3b, waveform A (the signal applied to the base of Q1) was fixed at approximately 5 volts DC bias, while the signal of waveform B is switched between 2 and 8 volts DC bias. Referring to FIGURE 3, the bias for transistor Q2 is set by resistors R3 and R4, but is controlled by a switching transistor Q3 which receives a control signal via resistor R305 from terminal 310. This control signal is provided by a controller (not shown) in order to select signals from source 10 or source 20. A high level signal at terminal 310 initiates conduction of transistor Q303 through resistor R303, causing the base bias of transistor Q2 to be altered to approximately 2 volts DC. A low level signal at terminal 310 turns transistor Q303 off, causing the base bias of transistor Q2 to be at approximately 8 volts DC.

Although transistor switching arrangement 100 was shown as including only two transistors, it is herein recognized that additional transistors may be connected in the same fashion. Accordingly, the scope of the claims is not intended to be limited to a two transistor arrangement.

Additionally, the scope of the claims is not intended to be limited to the use of bipolar transistors because it is recognized that FET devices are also suitable for use in practicing the invention.

## Claims

1. Signal switching circuitry comprising:
a first analog signal and bias source (10) for producing a first analog signal at a given bias level;
a second analog signal and bias source (20) for producing a second analog signal at a given bias level;
a transistor arrangement (100) including first and second transistors (Q1, Q2) configured as a non-additive mixer having respective first and second inputs (out 3, out 2) and a common output 40; and characterized by
first switch means (SW1) having an input terminal coupled to said first analog signal and bias source (10) for receiving said first analog signal at a bias level, a control terminal (C1) for controlling said switch in response to a first control signal, and an output terminal (out 1) coupled to said first input terminal of said non-additive mixer (100), at which is developed said first analog signal in response to said first control signal; and
second switch means (SW2) having an input terminal coupled to said second analog signal and bias source (20) for receiving said second analog signal at a bias level, a control terminal (C2) for controlling said second switch means (SW2) in response to a second control signal complementary to said first control signal; and an output terminal (out 2) coupled to said second input terminal of said non-additive mixer (100), at which is developed said second analog signal in response to said second control signal;
said respective inputs (out 1, out 2) of said first and second transistors being coupled to a reference level when the respective switch means (SW1, SW2) is non-conductive;
said first transistor (Q1) being non-conductive when said first switch means (SW1) is non-conductive, and said second transistor (Q2) being conductive when said second switch means (SW2) is conductive.

FIG. 1a

FIG.1

EP 0 393 947 A2

FIG. 2

IN

EP 0 393 947 A2

**FIG. 3**

EP 0 393 947 A2

FIG. 3a.

FIG. 3b.